**Europäisches Patentamt**

**European Patent Office**

**Office européen des brevets**

(19)

(11) Veröffentlichungsnummer: **0 321 565**
**A1**

(12) **EUROPÄISCHE PATENTANMELDUNG**

veröffentlicht nach Art. 158 Abs. 3 EPÜ

(21) Anmeldenummer: **87906038.2**

(22) Anmeldetag: **19.06.87**

Daten der zugrundeliegenden internationalen Anmeldung:

(86) Internationale Anmeldenummer:
**PCT/SU 87/00076**

(87) Internationale Veröffentlichungsnummer:
**WO 88/10535 (29.12.88 88/28)**

(51) Int. Cl.⁴: **H 03 K 17/68**

(43) Veröffentlichungstag der Anmeldung: **28.06.89**
**Patentblatt 89/26**

(84) Benannte Vertragsstaaten: **BE DE FR GB IT**

(71) Anmelder: **BELORUSSKY GOSUDARSTVENNY UNIVERSITET IMENI V.I.LENINA, Leninsky pr., 4, Minsk, 220080 (SU)**

(72) Erfinder: **SIDORUK, Sergei Nikolaevich, ul. Kurchatova, 6-814, Minsk, 220106 (SU)**

(74) Vertreter: **Nix, Frank Arnold, Dr., Kröckelbergstrasse 15, D-6200 Wiesbaden (DE)**

(54) **WECHSELSPANNUNGSSCHALTER.**

(57) Wechselspannungsumschalter mit einem Transformator (1), bei dem die Primärwicklung (2) an das Wechselstrom-Speisenetz angeschlossen ist und zwei Sekundärwicklung (3, 13) mit ihren ersten Anschlüssen (4, 12) an die ersten Anschlüsse (5, 11) von zweiseitig leitenden Schaltern (6, 9) und an die Eingänge (42, 43) einer Baueinheit (34) zur Bestimmung der Polarität der Speisenetzspannung geschaltet sind, während die zweiten Anschlüsse (15, 14) der Sekundärwicklungen (3, 13) zusammengeschaltet und geerdet sind. An die Steuereingänge (17, 18, 19, 20) der zweiseitig leitenden Schalter (6, 9) sind die Ausgänge (21, 22, 23, 24) von Einheiten (25, 26) zur Umsetzung der Steuersignalamplitude angeschlossen, deren Steuereingänge (27, 35, 36, 28) mit den Ausgängen (29, 31, 38, 40) von Baueinheiten (33, 41) zur Steuerung der zweiseitig leitenden Schalter verbunden sind, an welche die Ausgänge (30, 32, 37, 39) der Baueinheit (34) zur Bestimmung der Polarität der Speisenetzspannung angeschlossen sind.

EP 0 321 565 A1

WECHSELSPANNUNGSUMSCHALTER

## Gebiet der Technik

Die Erfindung betrifft die Impulstechnik, insbesondere einen Wechselspannungsumschalter.

## Stand der Technik

Zur Zeit werden weitgehend Wechselspannungsumschalter angewandt, die zur Stromsteuerung in einer Wirk- und induktiven Belastung (z.B. in Wicklungen elektrischer Maschinen) durch Impulsbreitenmodulation der Speisenetzspannung bestimmt sind. Die heutigen Wechselspannungsumschalter sind aber zur Realisierung nur von wenigen Algorithmen der Stromsteuerung in ohmschen und induktiven Belastungen geeignet, da sie Einschränkungen für die Dauer und Phase der impulsbreitenmodulierten Steuerungssignale auferlegen. Das Fehlen von Mitteln zur Rückgewinnung der in der Wirk- und induktiven Last gespeicherten elektromagnetischen Energie schließt bei den gegenwärtigen Umschaltern die Möglichkeit aus, die Belastung beim Nichtverschwinden ihres Stromes unzuschalten und dadurch den Betrieb der Belastung mit kontinuierlichem Stromfluß zu realisieren, wobei das Anwendungsgebiet und die Funktionsmöglichkeiten des Umschalters im wesentlichen eingeschränkt werden.

Es ist ein Umschalter (vgl. O.A. Kossov "Leistungsverstärker mit Transistoren im Schaltbetrieb", 1971, Verlag "Energija", Moskau, S. 72) bekannt, der eine Wechselspannungsquelle enthält, die mit einer Belastung und einem zweiseitig leitenden Schalter in Reihe geschaltet ist, der mit zwei bipolaren Transistoren aufgebaut ist, bei denen parallel zum Kollektor-Emitter-Übergang und zum Basis-Emitter-Übergang Dioden in Sperrichtung liegen, wobei die Basiselektroden der Transistoren als Eingänge des Schalters benutzt werden und an Steuerspannungsquellen angeschlossen sind.

Beim beschriebenen Umschalter gibt es keine Einschränkungen für den Anschlußzeitpunkt der ohmschen-induktiven Last an die Wechselspannungsquelle, aber die Abschaltung der Last von der Spannungsquelle ist nur beim Laststrom gleich Null möglich, wobei sich strenge Forderungen an die Dauer und den Zeitpunkt der Ankunft von
Impulsen am Steuereingang des Umschalters ergeben und
seine Funktionsmöglichkeiten wesentlich eingeschränkt
werden.

Ein anderer bekannter Wechselspannungsumschalter
(SU, A, 1198686) enthält einen Transformator, dessen
Primärwicklung an das Wechselstrom-Speisenetz angeschlossen ist und dessen Sekundärwicklung mit ihrem ersten
Anschluß am ersten Anschluß eines zweiseitig leitenden
Schalters liegt, bei dem der zweite Anschluß als erster
Ausgang des Umschalters dient, dessen zweiter Ausgang
vom zweiten Anschluß der Sekundärwicklung des Transformators gebildet wird, wobei die Steuereingänge des zweiseitig leitenden Schalters an die Ausgänge einer Einheit
zur Umsetzung der Steuersignalamplitude angeschlossen
sind, deren Steuereingänge mit dem Steuereingang des Umschalters elektrisch verbunden sind. Der zweiseitig leitende Schalter enthält zwei n-p-n-Transistoren, bei denen die Emitter zusammengeschaltet sind, die Kollektoren als Schalteranschlüsse dienen und die Basiselektroden die Steuereingänge des Schalters bilden. Zum Schalter gehören auch zwei Dioden, deren Katoden an die Kollektoren der n-p-n-Transistoren angeschlossen sind. Die
Einheit zur Umsetzung der Steuersignalamplitude enthält
zwei Widerstände, deren erste Anschlüsse als Ausgänge
der Einheit dienen und deren zweite Anschlüsse miteinander verbunden sind und den Steuereingang der Einheit bilden, der mit dem Steuereingang des Umschalters über einen
Anpassungstransformator in elektrischer Verbindung steht,
wobei die Mittelanzapfung der Sekundärwicklung dieses
Transformators an die Anoden der ersten und der zweiten
Diode angeschlossen ist.

- 3 -

Der Anschluß der Belastung an das Wechselstrom-Speisenetz erfolgt in diesem Umschalter bei der Ankunft eines positiven Impulses an der Primärwicklung des Anpassungstransformators, und dabei ist die Abschaltung der ohmschen und induktiven Belastung vom Wechselstrom-Speisenetz beim Nichtverschwinden des Belastungstromes unmöglich, da infolge der in der Belastungsinduktivität gespeicherten elektromagnetischen Energie und wegen fehlender Mittel zu ihrer Rückgewinnung ein Durchbruch des zweiseitig leitenden Schalters entsteht.

Also ist dieser bekannte Wechselspannungsumschalter durch begrenzte Funktionsmöglichkeiten gekennzeichnet, die es nicht gestatten, die Kommutierung der Wirk- und induktiven Belastung nach beliebigen geforderten Gesetzen durchzuführen.

Offenbarung der Erfindung

Der Erfindung liegt die Aufgabe zugrunde, einen Wechselspannungsumschalter zu entwickeln, in dem durch Einführung von zusätzlichen Baueinheiten zur Rückgewinnung der in einer Wirk- und induktiven Last gespeicherten elektromagnetischen Energie die Umschaltung der Belastung in beliebig gewählten Zeitpunkten unabhängig von ihrem jeweiligen Stromwert erfolgen kann.

Diese Aufgabe ist dadurch gelöst, daß im Wechselspannungsumschalter, der einen Transformator enthält, dessen Primärwicklung an das Wechselstrom-Speisenetz angeschlossen ist und dessen Sekundärwicklung mit ihrem ersten Anschluß am ersten Anschluß eines zweiseitig leitenden Schalters liegt, bei dem der zweite Anschluß als erster Ausgang des Umschalters dient, dessen zweiter Ausgang vom zweiten Anschluß der Sekundärwicklung des Transformators gebildet wird, während die Steuereingänge des zweiseitig leitenden Schalters an die Ausgänge einer Einheit zur Umsetzung der Steuersignalamplitude angeschlossen sind, deren Steuereingänge mit dem Steuereingang des Umschalters elektrisch verbunden sind, - der Transformator erfindungsgemäss mit einer zusätzlichen Sekundärwicklung versehen ist, deren erster Anschluss mit dem zweiten Anschluss der Hauptsekundärwicklung verbunden und geerdet ist, wobei der Umschalter durch einen zusätzlichen zweiseitig Schalter ergänzt ist, bei dem der erste Anschluss am zweiten Anschluss der zusätzlichen Sekundärwicklung der Transformators und der zweite Anschluss am zweiten Anschluss des zweiseitig leitenden Hauptschalters liegen, und mit einer zusätzlichen Einheit zur Umsetzung der Steuersignalamplitude ausgestattet ist, deren Ausgänge an die Steuereingänge des zusätzlichen zweiseitig leitenden Schalters angeschlossen sind, sowie durch eine Baueinheit zur Bestimmung der Polarität der Speisenetzspannung erweitert ist, deren Eingänge mit dem ersten Anschluss der Hauptsekundärwicklung und mit dem zweiten Anschluss der zusätzlichen Sekundärwicklung des Transformators verbunden sind, und mit zwei Baueinheiten zur Steuerung der zweiseitig leitenden Schalter versehen ist, deren Eingänge als Hauptsteuereingang und als zusätzlicher Steuereingang des Umschalters dienen, wobei die Ausgänge der Steuereinheiten und der Baueinheit zur Bestimmung der Polarität der Speisenetzspannung an die Steuereingänge der Haupteinheit und der zusätzlichen Einheit zur Umsetzung der Steuersignalamplitude angeschlossen sind.

Der Hauptschalter und der zusätzliche Schalter mit zweiseitigen Leitfähigkeit können zweckmässigerweise folgende Bauelemente enthalten: einen p-n-p-Transistor, dessen Emitter als erster Anschluss des Schalters dient; eine erste Diode, deren Katode und Anode an den Emitter bzw.an den Kollektor des p-n-p-Transistors angeschlossen sind; einen n-p-n-Transistor, bei dem der Emitter am Kollektor des p-n-p-Transistors liegt und der Kollektor als zweiter Anschluss des zweiseitig leitenden Schalters benutzt wird; eine zweite Diode, deren Katode und Anode mit dem Kollektor bzw. mit dem Emitter des n-p-n-Transistors verbunden sind; vier Widerstände, bei denen die einen Anschlüsse des ersten und des zweiten Widerstandes an die Emitter des p-n-p- bzw. n-p-n-Transistors angeschlossen sind und die einen Anschlüsse des dritten und vierten Widerstandes entsprechenderweise an den Basen dieser Transistoren liegen; eine dritte und eine vierte Diode, deren Katoden mit den anderen Anschlüssen des dritten bzw. vierten Widerstandes verbunden sind; zwei Drosseln, die parallel zur dritten und zur vierten Diode geschaltet sind, wobei die Anode der dritten und die Katode der vierten Diode als Steuereingänge des zweiseitig leitenden Schalters benutzt werden.

Es ist von Vorteil, den Wechselspannungsumschalter zusätzlich mit zwei Quellen positiver Spannung und mit einer Quelle negativer Spannung zu versehen und die Haupteinheit sowie die zusätzliche Einheit zur Umsetzung der Steuersignalamplitude mit folgenden Bauelementen aufzubauen: mit je zwei p-n-p-Transistoren, deren Emitter entsprechenderweise an die Quellen positiver Spannung angeschlossen sind; mit einem n-p-n-Transistor, dessen Emitter an die Quelle negativer Spannung geschaltet ist; mit drei Paaren von Widerständen, bei denen die einen Anschlüsse in jedem Paar zusammengeschaltet sind und beim ersten und zweiten Paar als Steuereingänge der Einheit zur Umsetzung der Steuersignalamplitude dienen, während die zusammengeschalteten Anschlüsse des dritten Paares von Widerständen an den Kollektor des ersten p-n-p-Transistors angeschlossen sind, wobei die anderen Anschlüsse jedes Paares von Widerständen mit den Basiselektroden und den Emittern des p-n-p- bzw. n-p-n-Transistors verbunden sind; mit zwei Kondensatoren, die an den Basen und den Kollektoren des n-p-n-Transistors bzw. des zweiten p-n-p-Transistors liegen, deren Kollektoren die Ausgänge der Einheit zur Umsetzung der Steuersignalamplitude bilden.

Zweckmäßigerweise kann die Baueinheit zur Bestimmung der Polarität der Speisenetzspannung folgende Bauelemente enthalten: vier n-p-n-Transistoren, bei denen die Emitter geerdet sind und die Kollektoren als Ausgänge dieser Baueinheit dienen; vier Widerstände, bei denen die einen Anschlüsse an die Basen der n-p-n-Transistoren angeschlossen sind und die anderen paarweise miteinander verbunden sind; zwei Dioden, deren Katoden mit den zusammengeschalteten Anschlüssen der Widerstände verbunden sind und deren Anoden die Eingänge der Baueinheit zur Bestimmung der Polarität der Speisenetzspannung bilden.

Bevorzugt ist der Aufbau jeder Baueinheit zur Steuerung des zweiseitig leitenden Schalters mit zwei n-p-n--Transistoren, deren Emitter geerdet sind, sowie mit zwei Widerständen, bei denen die einen Anschlüsse zusammengeschaltet sind und als Eingang dieser Baueinheit dienen und die anderen Anschlüsse an die Basen der n-p-n-Transistoren angeschlossen sind, deren Kollektoren als Ausgänge der Baueinheit zur Steuerung des zweiseitig leitenden Schalters benutzt werden.

Der angemeldete Wechselspannungsumschalter ermöglicht die Umschaltung einer Wirk- und induktiven Belastung in Bedarfszeitpunkten unabhängig von den jeweiligen Belastungsstromwerten und von der Speisenetzspannung. Diese Erweiterung seiner Funktionsmöglichkeiten wird im Ergebnis der Ergänzung des Umschalters durch einen zusätzlichen zweiseitig leitenden Schalter und durch eine zusätzliche Sekundärwicklung des Transformators erreicht, welche die Rücklieferung der in der Wirk- und induktiven Belastung gespeicherten überschüssigen elektromagnetischen Energie unmittelbar in das Speisenetz ermöglichen und dadurch die Umschaltung der Belastung nach beliebigen geforderten Gesetzen gestatten. Die Steuerung des zweiseitig leitenden Hauptschalters und des zusätzlichen zweiseitig leitenden Schalters erfolgt mit Hilfe der Einheiten zur Umsetzung der Steuersignalamplitude, der Baueinheit zur Bestimmung der Polarität der Speisenetzspannung und der Steuereinheiten. Bei dem im Umschalter benutzten Transformator mit zwei Sekundärwicklungen kann jede geforderte Polarität der Spannung an der Belastung unabhängig von der jeweiligen Polarität der Speisenetzspannung erhalten werden. Die Rücklieferung der überschüssigen elektromagnetischen Energie unmittelbar in das Speisenetz trägt auch zur Erhöhung des Wirkungsgrades des Umschalters bei.

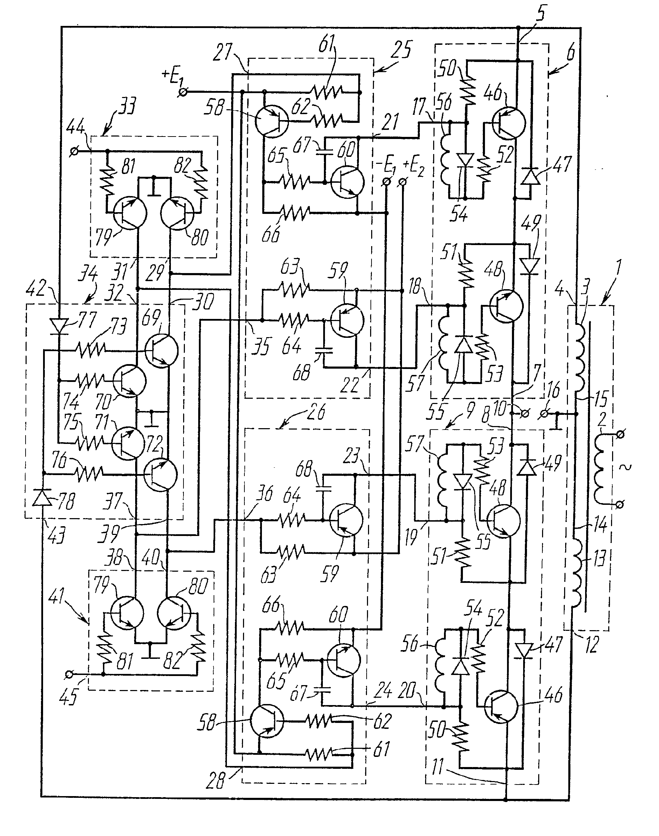

## Kurze Beschreibung der Zeichnung

Die Erfindung wird in der nachstehenden Beschreibung einer konkreten Variante ihrer Ausführung und anhand der beigefügten Zeichnung näher erläutert, in der das elektrische Prinzipschaltbild des Wechselspannungsumschalters gemäß der Erfindung dargestellt ist.

## Bevorzugte Ausführungsvariante der Erfindung

Der Wechselspannungsumschalter enthält einen Transformator 1, bei dem die Primärwicklung 2 an das Wechselstrom-Speisenetz angeschlossen ist ( in der Zeichnung sind nur die Eingangsklemmen des Transformators 1 gezeigt) und die Sekundärwicklung 3 mit ihrem Anschluß 4 am ersten Anschluß 5 eines zweiseitig leitenden Schalters 6 liegt. Der zweite Anschluß 7 des Schalters 6 ist mit dem ersten Anschluß 8 eines anderen zweiseitig leitenden Schalters 9 verbunden und bildet den ersten Ausgang 10 des Umschalters. Der Anschluß 11 des Schalters 9 ist an den Anschluß 12 einer Sekundärwicklung 13 des Transformators 1 angeschlossen, und der andere Anschluß 14 dieser Wicklung 13 ist mit dem Anschluß 15 der Sekundärwicklung 3 verbunden, der geerdet ist und als zweiter Ausgang 16 des Wechselspannungsumschalters dient. Die Ausgänge 10 und 16 des Umschalters sind zum Anschalten einer Wirk- und induktiven Belastung, z.B. der Wicklung einer elektrischen Maschine bestimmt.

Die Steuereingänge 17, 18 und 19, 20 der zweiseitig leitenden Schalter 6, 9 sind an die Ausgänge 21, 22 und 23, 24 der Einheiten 25, 26 zur Umsetzung der Steuersignalamplitude angeschlossen, deren Steuereingänge 27, 28

- 8 -

an den paarweise zusammengeschalteten Ausgängen 29, 30 bzw. 31, 32 der Baueinheit 33 zur Steuerung des zweiseitig leitenden Schalters und der Baueinheit 34 zur Bestimmung der Polarität der Speisenetzspannung liegen, während die Steuereingänge 35, 36 der Einheiten 25, 26 zur Umsetzung der Steuersignalamplitude mit den paarweise zusammengeschalteten Ausgängen 37, 38 bzw. 39, 40 der Baueinheit 34 zur Polaritätsbestimmung und der Baueinheit 41 zur Steuerung des zweiseitig leitenden Schalters verbunden sind.

Die Eingänge 42, 43 der Baueinheit 34 zur Bestimmung der Polarität der Speisenetzspannung liegen an den Anschlüssen 4 bzw. 12 der Sekundwicklungen 3, 13 des Transformators 1. Die Eingänge 44, 45 der Steuereinheiten 33, 41 dienen als Steuereingänge des Umschalters.

Jeder zweiseitig leitende Schalter 6, 9 enthält einen p-n-p-Transistor 46, dessen Emitter als erster Anschluß 5 bzw. 11 der Schalter 6, 9 dient, sowie eine Diode 47, deren Katode und Anode an den Emitter bzw. an den Kollektor des p-n-p-Transistors 46 angeschlossen sind, und einen n-p-n-Transistor 48, bei dem der Emitter am Kollektor des p-n-p-Transistors 46 liegt und der Kollektor als zweiter Anschluß 7, 8 des Schalter 6 bzw. 9 dient. Mit dem Kollektor und dem Emitter des n-p-n-Transistors 48 sind Katode bzw. Anode einer Diode 49 verbunden, und an die Emitter des p-n-p-Transistors 46 und des n-p-n-Transistors 48 sind mit einem Anschluß die Widerstände 50 bzw. 51 angeschaltet. Die Basen dieser Transistoren sind jeweils mit einem Anschluß der Widerstände 52 und 53 verbunden. An die anderen Anschlüsse der Widerstände 52, 51 sind die Katoden der Dioden 54, 55 angeschlossen, deren Anoden mit den anderen Anschlüssen der Widerstände 50, 53 verbunden sind. Parallel zu den Dioden 54, 55 liegen Drosseln 56, 57, wobei die Anode der Diode 54 und die Katode der Diode 55 als Steuereingänge 17, 20, 18, 19 der Schalter 6 und 9 benutzt werden.

In jeder Einheit 25, 26 zur Umsetzung der Steuersignalamplitude sind zwei p-n-p-Transistoren mit ihren Emittern an die Quellen $+E_1$, $+E_2$ positiver Spannung angeschlossen, während mit der Quelle -E negativer Spannung der Emitter des n-p-n-Transistors 60 verbunden ist. Drei Paare von Widerständen 61, 62, 63, 64, 65, 66 jeder Einheit 25, 26 zur Umsetzung der Steuersignalamplitude sind in jedem Paar mit den einen Anschlüssen zusammengeschaltet, die bei den Paaren von Widerständen 61, 62 und 63, 64 als Steuereingänge 27, 28, 35, 36 dieser Umsetzereinheiten 25, 26 dienen. Die zusammengeschalteten Anschlüsse des dritten Paares von Widerständen 65, 66 sind an den Kollektor des p-n-p-Transistors 58 angeschlossen, während die anderen Anschlüsse von Widerständen 61, 62, 63, 64, 65, 66 an der Basis bzw. am Emitter der p-n-p-Transistoren 58, 59 und der n-p-n-Transistoren 60 liegen. Mit den Basis- und Kollektorelektroden der n-p-n-Transistoren 60 und des p-n-p-Transistors 59 sind Kondensatoren 67, 68 verbunden, wobei die Kollektoren dieser Transistoren 60, 59 die Ausgänge 21, 24, 22, 23 der Einheiten 25, 26 zur Umsetzung der Steuersignalamplitude bilden.

Die Baueinheit 34 zur Bestimmung der Polarität der Speisenetzspannung enthält bei dieser Ausführungsvariante vier n-p-n-Transistoren 69, 70, 71, 72, deren Emitter geerdet sind und deren Kollektoren als Ausgänge 30, 32, 37, 39 der Baueinheit zur Bestimmung der Polarität der Speisenetzspannung dienen. An die Basen der n-p-n-Transistoren 69, 70, 71, 72 sind mit einem Anschluß die Widerstände 73, 74, 75, 76 angeschlossen, wobei die anderen Anschlüsse der Widerstände 74, 75 und 73, 76 paarweise zusammengeschaltet und mit den Katoden von Dioden 77, 78 verbunden sind, deren Anoden die Eingänge 42, 43 der Baueinheit 34 zur Bestimmung der Polarität der Speisenetzspannung bilden.

Jede Baueinheit 33, 41 zur Steuerung des zweiseitig leitenden Schalters enthält zwei n-p-n-Transistoren 79, 80, bei denen die Emitter geerdet sind, die Kollektoren als Ausgänge 31, 38 und 29, 40 der Steuereinheiten 33, 41 benutzt werden und die Basen mit den einen Anschlüssen von Widerständen 81, 82 verbunden sind, deren andere Anschlüsse miteinander verbunden sind und als Eingänge 44, 45 der Steuereinheiten 33, 41 dienen.

Der Wechselspannungsumschalter funktioniert wie folgt.

Der Umschalter ist zur Impulsbreiten-Stromsteuerung einer Wirk- und induktiven Belastung bestimmt, die an die Anschlüsse 10, 16 des Umschalters angeschaltet wird. Die Belastungsstromamplitude wird durch das Tastverhältnis der positiven Impulse bestimmt, die einem der Eingänge 44, 45 der Steuereinheiten 33, 41 zugeführt werden. Bei der Ankunft der Impulse am Eingang 44 der Steuereinheit 33 fließt der Belastungsstrom vom Ausgang 10 zum Ausgang 16 des Umschalters in bedingt positiver Richtung unabhängig von der jeweiligen Polarität der Speisenetzspannung, während bei der Zuführung der Impulse über den Eingang 45 der Steuereinheit 41 der Belastungstrom in entgegengesetzter Richtung fließt.

Die Bildung der vorgegebenen Polarität des Belastungsstromes wird wie folgt erreicht. Beim Erscheinen eines positiven Impulses am Eingang 44 der Steuereinheit 33 werden die n-p-n-Transistoren 79, 80 durch den über die Widerstände 81, 82 fließenden Strom geöffnet. Die Öffnung der Transistoren 79, 80 der Steuereinheit 33 führt zum Entsperren der p-n-p-Transistoren 58 der Einheiten 25, 26 zur Umsetzung der Steuersignalamplitude über die Widerstände 62.

Im Ergebnis dieser Vorgänge erhöht sich die Spannung an den Kollektoren der p-n-p-Transistoren 58 praktisch bis zum Spannungswert $+E_1$ der ersten Quelle positiver Spannung, und dies bewirkt die Öffnung der n-p-n-Transistoren 60 durch den Strom, der von den Kollektoren der p-n-p-Transistoren 58 über die Widerstände 65 zur Quelle

- 11 -

negativer Spannung -E fließt.

Um das sichere Öffnen der p-n-p-Transistoren 58 der Baueinheiten 25, 26 zur Umsetzung der Steuersignalamplitude zu gewährleisten, wird die positive Spannung der ersten Quelle +$E_1$ beabsichtigt höher als die Summe der Sättigungsspannungen der Basis-Emitter-Übergänge der p-n-p-Transistoren 58 und der Kollektor-Emitter-Übergänge der n-p-n-Transistoren 69, 70, 79, 80 der Baueinheit 34 zur Bestimmung der Polarität der Speisenetzspannung bzw. der Steuereinheiten 33, 41 gewählt.

An den Kollektoren der n-p-n-Transistoren 60, die als Ausgänge 21, 24 der Einheiten 25, 26 zur Umsetzung der Steuersignalamplitude dienen, sinkt die Spannung infolge der beschriebenen Vorgänge praktisch bis auf die Spannungsgröße von -E der Quelle negativer Spannung, die bewußt größer als die Wechselspannungsamplitude der Wicklungen 3, 13 des Transformators 1 gewählt wird. Deswegen fließt der Strom von der Anschlüssen 4, 12 der Wicklungen 3, 13 des Transformators 1 über die Widerstände 52, die Drosseln 56 und die Basis-Emitter-Übergänge der p-n-p-Transistoren 46 in den zweiseitig leitenden Schaltern 6, 9 zur Quelle negativer Spannung -E unabhängig von den jeweiligen Werten der genannten Spannungen.

Die Drosseln 56 und die Kondensatoren 67 begrenzen die Anstiegssteilheit des Basisstromes der Transistoren 46 und verhindern dadurch den Querstromfluß im Zeitpunkt der Umschaltung der p-n-p-Transistoren 46 zwischen den Anschlüssen 4, 12 der Sekundärwicklungen 3, 13 des Transformators 1. Die Dioden 54 verhindern den Durchbruch der n-p-n-Transistoren 60 bei der Umschaltung der Drosseln 56.

Der in Durchlaßrichtung durch die Basis-Emitter-Übergänge der Transistoren 46 fließende Strom führt zu deren Öffnung, wobei je nach der wirksamen Polarität der Spannung an den Anschlüssen 4, 12 der in Reihe geschalteten Wicklungen 3, 13 des Transformators 1 einer der p-n-p-Transistoren 46 sich in direkter und der andere in inverser Schaltung erweist. Bei positiver Spannung am Anschluß 4 der Wicklung 3 des Transformators 1 ist der p-n-p-Transistor 46 des Schalters 9 invers geschaltet, und umgekehrt. Den Durchbruch des invers geschalteten p-n-p-Transistors 46 durch die Rückwärtsspannung verhindert die Diode 47, die in diesem Falle in Durchlaßrichtung geschaltet ist.

Beim Erscheinen eines positiven Impulses am Eingang 44 der Steuereinheit 33 wird also am Ausgang 10 des Wechselspannungsumschalters mit Hilfe eines bei der jeweiligen Polarität der Spannung des Wechselstrom-Speisenetzes direkt geschalteten p-n-p-Transistors 46 der beiderseits leitenden Schalter 6, 9 ein positiver Impuls erzeugt, dessen Amplitude praktisch mit dem wirksamen Spannungswert an den Anschlüssen 4, 12 der Wicklung 3, 13 des Transformators 1 übereinstimmt.

Bei der Ankunft eines positiven Impulses am Eingang 45 der Steuereinheit 41 werden die n-p-n-Transistoren 79, 80 durch den über die Widerstände 81, 82 fließenden Strom geöffnet. Die Öffnung dieser n-p-n-Transistoren 79, 80 führt zum Entsperren der p-n-p-Transistoren 59 in den Einheiten 25, 26 zur Umsetzung der Steuersignalamplitude, und zwar durch den Strom, der von der zweiten Quelle $+E_2$ positiver Spannung über die Basis-Emitter-Übergänge der p-n-p-Transistoren 59, die Widerstände 64 und die geöffneten n-p-n-Transistoren 79, 80 der Steuereinheit 41 fließt. Infolgedessen steigt die Spannung an den Kollektoren der p-n-p-Transistoren 59, die als Ausgänge 22, 23 der Einheiten 25, 26 dienen, praktisch bis zur Spannungsgröße $+E_2$ der zweiten Quelle positiver Spannung an. Da die Spannung $+E_2$ bewußt größer als die Wechselspannungsamplitude an den Anschlüssen 4, 12 der Wicklungen 3, 13 des Transformators 1 gewählt wird, fließt der Strom - unabhängig von den wirksamen Werten der genannten Spannungen - von der zweiten Quelle der positiven Spannung $+E_2$ über die geöffneten p-n-p-Transistoren 59, die Drosseln 57, die Widerstände 53 und die Basis-Emitter-Übergänge der n-p-n-Transistoren 48 der Schalter 6, 9 zu den Anschlüssen 4, 12 der Sekundärwicklungen 3, 13 des Transformators 1.

Die Drosseln 57 und die Kondensatoren 68 begrenzen die Anstiegssteilheit des Basisstromes der n-p-n-Transistoren 48 und verhindern dadurch den Querstromfluß im Zeitpunkt der Umschaltung der Transistoren 48 zwischen den Anschlüssen 4, 12 der Sekundärwicklungen 3, 13 des Transformators 1. Die Dioden 55 verhindern den Durchbruch der p-n-p-Transistoren 59 bei der Umschaltung der Drosseln 57.

Der in Durchlaßrichtung durch die Basis-Emitter-Übergänge der n-p-n-Transistoren 48 fließende Strom führt zu deren Öffnung, wobei im Falle der positiven Spannung am Anschluß 4 der Wicklung 3 des Transformators 1 der n-p-n-Transistor 48 des Schalters 9 direkt und der n-p-n-Transistor 48 des Schalters 6 invers geschaltet ist, und umgekehrt.

Den Durchbruch des invers geschalteten n-p-n-Transistors 48 verhindert die in diesem Falle in Durchlaßrichtung geschaltete Diode 49.

Beim Erscheinen eines positiven Impulses am Eingang 45 der Steuereinheit 41 wird also am Ausgang 10 des Wechselspannungsumschalters mit Hilfe eines bei der jeweiligen Polarität der Spannung des Wechselstrom-Speisenetzes direkt geschalteten n-p-n-Transistors 48 der zweiseitig leitenden Schalter 6, 9 ein negativer Impuls erzeugt, dessen Amplitude praktisch mit dem wirksamen Spannungswert an den Anschlüssen 4, 12 der Wicklungen 3, 13 des Transformators 1 übereinstimmt.

Die Widerstände 50, 51 verhindern die Öffnung der Transistoren 46, 48 durch den Rückwärtsstrom der Kollektoren von Transistoren 60, 59, und die Widerstände 66 schützen vor der Öffnung der Transistoren 60 durch den Kollektorrückwärtsstrom der Transistoren 58, während die Widerstände 61 die Öffnung der Transistoren 58 durch den Kollektor-Rückwärtsstrom der Transistoren 69, 80 und 70, 79 verhindern und die Widerstände 63 das Entsperren der Transistoren 59 durch den Kollektor-Rückwärtsstrom der Transistoren 71, 79 und 72, 80 nicht zulassen.

Beim angemeldeten Umschalter ist die Abschaltung der Steuersignale von den Eingängen 44, 45 der Steiereinheiten 33, 41 unabhängig vom jeweiligen Stromwert der Wirk- und induktiven Last möglich. Diese funktionelle Möglichkeit des Umschalters wird mit Hilfe der Baueinheit 34 zur Bestimmung der Polarität der Speisenetzspannung, der zweiseitig leitenden Schalter 6, 9 und der Sekundärwicklungen 3, 13 des Transformators 1 realisiert.

Bei positiver Spannung am Anschluß 4 der Wicklung 3 des Transformators 1 bewirkt der durch die Diode 77 und die Widerstände 74, 75 der Baueinheit 34 fließende Strom die Öffnung der n-p-n-Transistoren 70, 71, und dabei sinken ihre Kollektorspannungen praktisch bis auf Null. Die Spannungen an den Ausgängen 22, 24 der Einheiten 25, 26 zur Umsetzung der Steuersignalamplitude nehmen dabei die Werte $+E_2$ bzw. $-E$ an, und der n-p-n-Transistor 48 des zweiseitig leitenden Schalters 6 sowie der p-n-p-Transistor 46 des Schalters 9 werden nun invers betrieben. Wenn die Signale an den Eingängen 44, 45 der Steuereinheiten 33, 41 gleich Null sind und der vom Ausgang 10 zum Ausgang 16 des Umschalters fließende Strom von Null verschieden ist, wird der p-n-p-Transistor 46 des Schalters 9 direkt betrieben, und der Strom der Wirk- und induktiven Belastung wird über die Wicklung 13 des Transformators 1 geschlossen, wobei seine Stärke abnimmt, da die Spannung an der Wicklung 13 negativ ist. Beim Belastungsstromfluß vom Ausgang 16 zum Ausgang 10 des Umschalters wird der n-p-n-Transistor 46 des zweiseitig leitenden Schalters 6 in den direkten Betrieb überführt, wobei der Strom der Wirk- und induktiven Belastung über die Wicklung 3 des Transformators 1 geschlossen und schwächer wird, da die Spannung an der Wicklung 3 positiv ist.

Bei der positiven Polarität der Spannung am Anschluß 12 der Wicklung 13 des Transformators 1 bewirkt der die Diode 78 und die Widerstände 73, 76 der Baueinheit 34 durchfließende Strom die Öffnung der n-p-n-Transistoren 69, 72 und dabei sinken ihre Kollektorspannungen praktisch bis auf Null. Die Spannungen an den Ausgängen 21, 23 der zur Umsetzung der Steuersignalamplitude bestimmten Einheiten 25, 26 nehmen dabei die Werte -E bzw. $+E_2$ an, und der n-p-n-Transistor 46 des Schalters 6 sowie der n-p-n-Transistor 48 des Schalters 9 werden nun invers betrieben.

Wenn die Signale an den Eingängen 44, 45 der Steuereinheiten 33, 41 gleich Null sind und der vom Ausgang 10 zum Ausgang 16 des Umschalters fließende Belastungsstrom von Null verschieden ist, geht der Transistor 46 des Schalters 6 in den direkten Betrieb über, und der Strom der Wirk- und induktiven Belastung wird über die Wicklung 3 des Transformators 1 geschlossen, wobei seine Stärke abnimmt, da die Spannung an der Wicklung 3 negativ ist. Beim Belastungsstromfluß vom Ausgang 16 zum Ausgang 10 des Umschalters wird der n-p-n-Transistor 48 des zweiseitig leitenden Schalters 9 in den direkten Betrieb überführt, wobei der Strom der Wirk- und induktiven Belastung über die Wicklung 13 des Transformators 1 geschlossen und schwächer wird, da die Spannung an der Wicklung 13 positiv ist.

Wenn also die Steuersignale an den Eingängen 44, 45 der Steuereinheiten 33, 41 gleich Null sind, wird der Strom der Wirk- und induktiven Belastung über eine der Wicklungen 3, 13 des Transformators geschlossen, an der die Spannung im gegebenen Zeitpunkt eine Polarität hat, bei welcher die Stärke des Belastungsstromes abnimmt.

Im Ergebnis des beschriebenen Vorganges sinkt der Strom der Wirk- und induktiven Belastung, und die in ihr gespeicherte überschüssige elektromagnetische Energie wird in das Wechselstrom-Speisenetz über eine der Sekundärwicklungen 3, 13 des Transformators 1 zurückgeliefert.

Somit besitzt der angemeldete Wechselspannungsumschalter breitere Funktionsmöglichkeiten, die darin bestehen, daß die Polarität der Belastungsspannung von der jeweiligen Polarität der Speisenetzspannung unabhängig ist und durch die Impulszuführung zu einem der Eingänge 44, 45 der Steuereinheiten 33, 41 bestimmt wird. Dabei ist die Möglichkeit vorgesehen, diese Impulse in jedem beliebigen Zeitpunkt unabhängig vom jeweiligen Belastungsstromwert abzuschalten. Beim Abschalten der Impulse von den Eingängen 44, 45 der Steuereinheiten 33, 41 wird die in der Belastungsinduktivität gespeicherte überschüssige elektromagnetische Energie in das Netz zurückgeliefert, wobei der Wirkungsgrad des Umschalters höher wird.

Gewerbliche Anwendbarkeit

Die Erfindung kann für elektrische Antriebe elektromechanischer Roboter und numerisch gesteuerter Werkzeugmaschinen benutzt werden.

PATENTANSPRÜCHE

1. Wechselspannungsumschalter, der einen Transformator (1) enthält, dessen Primärwicklung (2) an das Wechselstromnetz angeschlossen ist und dessen Sekundärwicklung (3) mit ihrem ersten Anschluß (4) mit dem ersten Anschluß (5) eines zweiseitig leitenden Schalters (6) verbunden ist, bei dem der zweite Anschluß (7) als erster Ausgang (10) des Umschalters dient, dessen zweiter Ausgang (16) vom zweiten Anschluß (15) der Sekundärwicklung (3) des Transformators (1) gebildet wird, während die Steuereingänge (17, 18) des zweiseitig leitenden Schalters (6) an die Ausgänge (21, 22) einer Einheit (25) zur Umsetzung der Steuersignalamplitude angeschlossen sind, deren Steuereingänge (27, 35) mit dem Steuereingang des Umschalters elektrisch verbunden sind, d a - d u r c h   g e k e n n z e i c h n e t , daß der Transformator (1) mit einer zusätzlichen Sekundärwicklung (13) versehen ist, deren erster Anschluß (14) mit dem zweiten Anschluß (15) der Hauptsekundärwicklung (3) verbunden und geerdet ist, wobei der Umschalter durch einen zusätzlichen zweiseitig leitenden Schalter (9) ergänzt ist, bei dem der erste Anschluß (11) am zweiten Anschluß (12) der zusätzlichen Sekundärwicklung (13) des Transformators (1) und der zweite Anschluß (8) am zweiten Anschluß (7) des zweiseitig leitenden Hauptschalter (6) liegen, - und mit einer zusätzlichen Einheit (26) zur Umsetzung der Steuersignalamplitude ausgestattet ist, deren Ausgänge (23, 24) an die Steuereingänge (19, 20) des zusätzlichen zweiseitig leitenden Schalters (9) angeschlossen sind, - sowie durch eine Baueinheit (34) zur Bestimmung der Polarität der Speisenetzspannung erweitert ist, deren Eingänge (42, 43) mit dem ersten Anschluß (4) der Hauptsekundärwicklung (3) und mit dem zweiten Anschluß (12) der zusätzlichen Sekundärwicklung (13) des Transformators (1) verbunden sind, - und mit zwei Baueinheiten (33, 41) zur Steuerung der zweiseitig leitenden Schalter versehen ist, deren Eingänge (44, 45) als Hauptsteuereingang und als
zusätzlicher Steuereingang des Umschalters dienen, wobei die Ausgänge (29, 31, 38, 40, 30, 32, 37, 39) der
Steuereinheiten (33, 41) und der Baueinheit (34) zur
Bestimmung der Polarität der Speisenetzspannung an die
Steuereingänge (27, 28, 35, 36) der Haupteinheit (25)
und der zusätzlichen Einheit (26) zur Umsetzung der
Steuersignalamplitude angeschlossen sind.

2. Wechselspannungsumschalter nach Anspruch 1, d a -
d u r c h   g e k e n n z e i c h n e t, daß der zweiseitig leitende Hauptschalter (6) und der zusätzliche
zweiseitig leitende Schalter (9) mit folgenden Bauelementen aufgebaut sind: mit einem p-n-p-Transistor (46),
dessen Emitter als erster Anschluß (5, 11) jedes Schalters (6, 9) dient; mit einer ersten Diode (47), deren
Katode und Anode an den Emitter bzw. an den Kollektor
des p-n-p-Transistors (46) angeschlossen sind; einem
n-p-n-Transistor (48), bei dem der Emitter am Kollektor
des p-n-p-Transistors (46) liegt und der Kollektor als
zweiter Anschluß (7, 8) des zweiseitig leitenden Schalters     (9) benutzt wird; einer zweiten Diode (49),
deren Katode und Anode mit dem Kollektor bzw. mit dem
Emitter des n-p-n-Transistors (48) verbunden sind; mit
vier Widerständen (50, 51, 52, 53), bei denen die einen
Anschlüsse des ersten und des zweiten Widerstandes an
die Emitter des p-n-p- bzw. n-p-n-Transistors (46, 48)
angeschlossen sind und die einen Anschlüsse des dritten
und des vierten Widerstandes (52, 53) entsprechenderweise an den Basen dieser Transistoren liegen; mit einer dritten und einer vierten Diode (54, 55), deren Katoden mit den anderen Anschlüssen des dritten bzw. des
vierten Widerstandes (53, 52) verbunden sind; mit zwei
Drosseln (56, 57), die parallel zur dritten und zur vierten Diode (54, 55) geschaltet sind, wobei die Anode der
dritten und die Katode der vierten Diode (54 bzw. 55)
als Steuereingänge (17, 20, 18, 19) jedes zweiseitig leitenden Schalters (6, 9) benutzt werden.

3. Wechselspannungsumschalter nach Anspruch 2, g e - k e n n z e i c h n e t durch zwei zusätzlich eingeführte Quellen positiver Spannung ($+E_1$, $+E_2$) und eine Quelle negativer Spannung (-E) sowie durch den Aufbau der Haupteinheit und der zusätzlichen Einheit (25, 26) zur Umsetzung der Steuersignalamplitude mit folgenden Bauelementen: mit je zwei p-n-p-Transistoren (58, 59), deren Emitter entsprechenderweise an die Quellen positiver Spannung ($+E_1$, $+E_2$) angeschlossen sind; mit einem n-p-n-Transistor (60), dessen Emitter an die Quelle negativer Spannung (-E) geschaltet ist; mit drei Paaren von Widerständen (61, 62, 63, 64, 65, 66), bei denen die einen Anschlüsse in jedem Paar zusammengeschaltet sind und beim ersten und zweiten Paar als Steuereingänge (27, 28, 35, 36) der Einheit (25, 26) zur Umsetzung der Steuersignalamplitude dienen, während die zusammengeschalteten Anschlüsse des dritten Paares von Widerständen (65, 66) an den Kollektor des ersten p-n-p-Transistors (58) angeschlossen sind, wobei die anderen Anschlüsse jedes Paares von Widerständen (61, 62, 63, 64, 65, 66) mit den Basen und den Emittern des p-n-p- bzw. n-p-n-Transistors (58, 59 bzw. 60) verbunden sind; mit zwei Kondensatoren, die an den Basen und den Kollektoren des n-p-n-Transistors (60) bzw. des zweiten p-n-p-Transistors (59) liegen, deren Kollektoren die Ausgänge (21, 24, 22, 23) der Einheit (25, 26) zur Umsetzung der Steuersignalamplitude bilden.

4. Wechselspannungsumschalter nach einem der Ansprüche 1 bis 3, d a d u r c h   g e k e n n z e i c h n e t, daß die Baueinheit (34) zur Bestimmung der Polarität der Speisenetzspannung folgende Bauelemente enthält: vier n-p-n-Transistoren (69, 70, 71, 72), bei denen die Emitter geerdet sind und die Kollektoren als Ausgänge (30, 32, 37, 39) dieser Baueinheit (34) dienen; vier Widerstände (73, 74, 75, 76), bei denen die einen Anschlüsse an die Basen der n-p-n-Transistoren (69, 72) angeschlossen sind und die anderen paarweise miteinander verbunden sind; zwei Dioden (77,78), deren Katoden mit den paarweise zusammengeschalteten Anschlüssen der Widerstände (74, 75, 73, 76) verbunden sind und deren Anoden die Eingänge (42, 43) der Baueinheit (34) zur Bestimmung der Polarität der Speisenetzspannung bilden.

5. Wechselspannungsumschalter nach einem der Ansprüche 1 bis 4, gekennzeichnet durch den Aufbau jeder Baueinheit (33, 41) zur Steuerung des zweiseitig leitenden Schalters mit zwei n-p-n-Transistoren (79, 80), deren Emitter geerdet sind, sowie mit zwei Widerständen (81, 82), bei denen die einen Anschlüsse zusammengeschaltet sind und als Eingang (44, 45) der Baueinheit (33, 41) zur Steuerung des zweiseitig leitenden Schalters dienen und die anderen Anschlüsse an die Basen der n-p-n-Transistoren (79, 80) angeschlossen sind, deren Kollektoren als Ausgänge (31, 38, 29, 40) der Baueinheit (33, 41) zur Steuerung des zweiseitig leitenden Schalters benutzt werden.